# DEMANDE DE BREVET EUROPEEN

(11) **EP 3 620 747 A1**
(43) Date de publication de la demande: **11.03.2020**
(21) Numéro de dépôt: 18193525.5
(22) Date de dépôt: 10.09.2018
(51) Int. Cl.: G01C 17/38

(54) **CALIBRATION OU REGLAGE DE MAGNETOMETRE**

(71) Demandeur: Tissot S.A., 2400 Le Locle (CH)
(72) Inventeur: FRANZI, Edoardo, 1400 Cheseaux-Noréaz (CH); DUNBAR, Andrea, 2072 St-Blaise (CH); TÜRETKEN, Engin, 1024 Ecublens (CH); MOSER, Virginie, 2517 Diesse (CH); STADELMANN, Patrick, 2017 Boudry (CH); ZHOU, Lingchuan, 2074 Marin-Epagnier (CH)
(74) Mandataire: ICB SA

(57) **Abrégé**

Un aspect de l'invention se rapporte à un procédé de correction de mesures magnétométriques (10) réalisées par un magnétomètre monté sur un support mobile. Le support mobile porte un ou plusieurs capteurs de mouvement et/ou de position montés en relation fixe par rapport au magnétomètre. Le procédé comprend :
l'obtention de mesures magnétométriques (12) et de mesures de mouvement et/ou de position (14, 16) réalisées simultanément par les magnétomètres, respectivement les capteurs de mouvement et/ou de position pendant un intervalle de temps ;
l'inférence, par une unité de traitement, de mesures magnétométriques corrigées (28) sur la base des mesures magnétométriques (12) et des mesures de mouvement et/ou de position (14, 16) réalisées simultanément pendant l'intervalle de temps.

## Description

### Domaine technique et état de l'art

De manière générale, l'invention concerne un procédé de calibration et/ou de réglage d'un ou de plusieurs magnétomètres. L'invention s'intéresse plus précisément à corriger des mesures magnétométriques réalisées par un ou plusieurs magnétomètres sur un support mobile comportant en plus un ou plusieurs capteurs de mouvement et/ou de position.

De nos jours, la plupart des mobiles multifonction (en anglais « smartphones ») comportent une multitude de capteurs différents, p.ex. un récepteur GNSS (récepteur de signaux de radionavigation transmis par GNSS, c.-à-d. par un système de positionnement par satellites - GNSS étant l'acronyme du terme anglais « Global Navigation Satellite System »), des accéléromètres, des gyromètres, un magnétomètre, etc. Pour déterminer l'orientation du mobile multifonction dans le référentiel terrestre, le magnétomètre est, pour beaucoup d'applications, indispensable. Ceci est notamment le cas dans une application de navigation : un récepteur GNSS individuel a la capacité de déterminer la position et la vitesse de son centre d'antenne. Par contre l'orientation du récepteur GNSS dans le référentiel terrestre est difficile et nécessite, au moins, la connaissance de l'orientation initiale. La plupart des applications de navigation utilisent donc le magnétomètre quand il s'agit de déterminer l'orientation du mobile par rapport à la carte.

Les mesures du magnétomètre peuvent servir à indiquer la direction du Nord magnétique, voire, après correction pour la déclinaison magnétique, la direction du Nord géographique. L'erreur de mesure peut cependant atteindre plusieurs degrés, ce qui fait que les mesures du magnétomètre ne sont pas utilisables pour les applications de précision. On notera en particulier que cette erreur de mesure peut résulter d'interférences magnétiques présents dans des environnements extérieurs et/ou intérieurs qui sont beaucoup plus importantes que le champ magnétique terrestre et qui peuvent ainsi fausser considérablement les estimations de mesure, entraînant par exemple des dizaines de degrés d'erreurs.

Ce problème touche particulièrement les magnétomètres de faible coût, qui sont les plus répandus dans toutes sortes de terminaux mobiles. Une autre source d'erreurs est due au fait que le champ magnétique à la position du terminal mobile a d'autres contributions que le champ magnétique terrestre (qui est relativement faible) : des perturbations locales (aimants, masses métalliques, sources électromagnétiques) peuvent facilement fausser les mesures du magnétomètre.

La présente invention a comme objectif de pallier ce problème notamment, mais sans y être limitée, dans le cas des terminaux mobiles (p.ex. mobiles multifonction, tablettes, montres connectées, récepteurs GNSS/GPS, etc.)

### Description de l'invention

Un premier aspect de l'invention se rapporte à un procédé de correction de mesures magnétométriques réalisées par un magnétomètre monté sur un support mobile. Le support mobile porte, outre le magnétomètre, un ou plusieurs capteurs de mouvement et/ou de position montés en relation fixe par rapport au magnétomètre. Le procédé comprend :
∘ l'obtention de mesures magnétométriques et de mesures de mouvement et/ou de position réalisées simultanément par les magnétomètres, respectivement les capteurs de mouvement et/ou de position pendant un intervalle de temps ;
∘ l'inférence, par une unité de traitement (p.ex. un microprocesseur, un ensemble de microprocesseurs, un circuit logique programmable, un circuit intégré propre à une application, etc.), de mesures magnétométriques corrigées sur la base des mesures magnétométriques et des mesures de mouvement et/ou de position réalisées simultanément pendant ledit intervalle de temps.

Il convient de noter que le terme magnétomètre peut, dans le contexte de ce document, désigner un magnétomètre élémentaire (capable de mesurer le champ magnétique selon un axe) ou un magnétomètre à plusieurs (p.ex. deux ou trois) axes comprenant plusieurs magnétomètres élémentaires.

D'une part, les mesures magnétométriques réalisées par le magnétomètre pendant l'intervalle de temps indiquent l'évolution de la direction et/ou de la magnitude du champ magnétique externe dans le référentiel du support mobile pendant l'intervalle et donc également l'évolution de l'orientation du support mobile par rapport au champ magnétique externe.

D'autre part, les mesures de mouvement et/ou de position réalisées par les capteurs de mouvement et/ou de position indiquent les mouvements du support mobile pendant le même intervalle de temps.

L'inférence des mesures magnétométriques corrigées peut donc reposer sur les concordances et les divergences entre, d'une part, l'évolution de l'orientation du support mobile par rapport au champ magnétique externe et, d'autre part, les mouvements du support mobile notamment des mouvements de translation du support mobile au fil du temps. Il peut s'agir de mouvements de translation opérés dans plusieurs directions.

Si le champ magnétique terrestre était localement uniforme, on devrait constater (en l'absence d'erreurs de mesure et tant que le support mobile reste dans la zone locale) la concordance entre évolution de l'orientation du support mobile par rapport au champ magnétique externe et les mouvements du support mobile. En réalité, cette concordance ne sera pas parfaite, à cause des erreurs de mesure (dus notamment à la dérive/mouvement/mouvement en translation des capteurs) et à cause des perturbations du champ magnétique terrestre. De manière intuitive, les divergences observées pendant un intervalle de temps durant lequel le support mobile était en mouvement permettent de détecter et de quantifier des perturbations locales du champ magnétique. Ensuite, les mesures du magnétomètre peuvent être corrigées de sorte à éliminer ces perturbations. Dans certaines conditions, il sera également possible de (re)calibrer le magnétomètre : si on connait, avec une précision suffisante, le déplacement du support mobile dans un référentiel terrestre (p.ex. le WGS 84) et les mouvements propres du support mobile pendant le déplacement, on peut déduire les valeurs théoriques du vecteur de champ magnétique et les comparer aux valeurs mesurées.

De préférence, le support mobile comprend un ou plusieurs accéléromètres qui réalisent des mesures de mouvement et/ou de position.

De manière alternative, ou additionnellement, le support mobile est équipé d'un ou de plusieurs gyromètres qui réalisent des mesures de mouvement et/ou de position.

De manière particulièrement préférée, le support mobile comprendrait une centrale à inertie (en anglais : « inertial measurement unit » ou « IMU ») intégrant un ou plusieurs accéléromètres et un ou plusieurs gyromètres et qui réaliserait les mesures de mouvement et/ou de position.

De préférence, le ou les capteurs de mouvement sont réalisés comme des systèmes micro-électromécaniques (en anglais : « microelectromechanical systems » ou « MEMS »).

Selon un mode de réalisation particulièrement avantageux de l'invention, le support mobile est doté d'un un ou plusieurs capteurs de position, de préférence d'un ou de plusieurs récepteurs GNSS/GPS qui réalisent des mesures de mouvement et/ou de position.

Si le support mobile est équipé de plusieurs capteurs, p.ex. d'une centrale à inertie et d'un récepteur GNSS/GPS les mesures de mouvement et/ou de position peuvent être hybridées entre elles (p.ex. au moyen d'un filtre adaptatif ou un filtre de Kalman) dans une étape de prétraitement avant l'étape d'inférence des mesures magnétométriques corrigées.

De préférence, l'inférence des mesures magnétométriques corrigées est réalisée à la volée. L'intervalle de temps correspond, de préférence, à un intervalle de temps défini précédent l'instant de la détermination des valeurs corrigées. L'intervalle de temps peut être fixe par rapport à l'instant de la détermination. Il est toutefois possible de prévoir la possibilité d'adapter de manière dynamique les paramètres de l'intervalle de temps (début et durée). L'intervalle de temps a, de préférence, une durée de 30 s ou plus, p.ex. 1 minute ou plus, 2 minutes ou plus, 3 minutes ou plus, 4 minutes ou plus ou 5 minutes ou plus. La durée maximale de l'intervalle pourrait être dans la plage de 10 à 15 minutes.

Selon un mode de réalisation préféré de l'invention, le support mobile comprend un terminal mobile, p.ex. un téléphone portable ou une montre connectée.

De préférence, l'unité de traitement comprend un ou plusieurs microprocesseurs exécutant un programme dédié à l'inférence des mesures magnétométriques corrigées. L'étape d'inférer les mesures magnétométriques corrigées pourrait utiliser un filtre de Kalman ou un filtre adaptatif. De manière plus préférée, on utiliserait cependant un algorithme d'intelligence artificielle. Dans ce contexte, on entend par « algorithme d'intelligence artificielle » un algorithme mis en oeuvre par ordinateur qui a été entraîné (par apprentissage supervisé ou non) au moyen de données d'entraînement, à trouver une correction pour les mesures magnétométrique en fonction de l'historique des mesures magnétométriques ainsi que de mouvement et/ou de position enregistrées pendant l'intervalle de temps. L'algorithme d'intelligence artificielle peut comprendre, p.ex. un réseau bayésien, un réseau de neurones, une machine à vecteur de support, la méthode des k plus proches voisins, un algorithme génétique, un arbre décisionnel, une forêt d'arbres décisionnels, un modèle de mixture gaussienne, la régression logistique, l'analyse discriminante linéaire, ou une combinaison de ceux-ci.

Il a été expliqué plus haut qu'il est possible de corriger les mesures magnétométrique parce qu'elles doivent refléter approximativement les mêmes mouvements que les mesures de mouvement et/ou de position. En pratique, il est très difficile d'établir des règles de correction qui soient valables dans toutes les situations. Pour cette raison, recourir à un algorithme d'intelligence artificielle est considéré comme avantageux dans le cadre de l'invention.

Selon un mode de réalisation particulièrement préféré de l'invention, le procédé comprendrait la transmission de mesures magnétométriques et de mesures de mouvement et/ou de position réalisées simultanément (ou de grandeurs déduites de celles-ci) vers une plateforme informatique en nuage (en anglais « cloud computing platform ») et la réception de paramètres de mise à jour du logiciel exécuté par l'unité de traitement pour les mesures magnétométriques corrigées. La plateforme informatique en nuage serait dans ce cas en charge de collecter les données d'un grand nombre d'utilisateurs et de les « digérer » pour améliorer l'algorithme de correction. Cet aspect interactif serait particulièrement utile dans le contexte d'un algorithme d'intelligence artificielle.

Un deuxième aspect de l'invention concerne un terminal mobile, p.ex. une montre connectée ou un téléphone portable, comprenant un magnétomètre, un ou plusieurs capteurs de mouvement et/ou de position montés fixement par rapport au magnétomètre, et une unité de traitement reliée au magnétomètre et au(x) capteur(s) de mouvement et/ou de position pour obtenir des mesures magnétométriques et des mesures de mouvement et/ou de position réalisées simultanément par les magnétomètres, respectivement le(s) capteur(s) de mouvement et/ou de position pendant un intervalle de temps. L'unité de traitement est configurée, au moyen d'un programme informatique, pour inférer des mesures magnétométriques corrigées sur la base des mesures magnétométriques et des mesures de mouvement et/ou de position réalisées simultanément pendant l'intervalle de temps.

Un autre aspect de l'invention porte sur un programme d'ordinateur comprenant des instructions de code de programme pour l'exécution des étapes de ce procédé lorsque ledit programme est exécuté par une unité de traitement du terminal mobile.

### Brève description des figures

D'autres particularités et caractéristiques de l'invention ressortiront de la description détaillée de certains modes de réalisation avantageux présentés ci-dessous, à titre d'illustration, avec référence aux dessins annexés qui montrent :
Fig.1: le schéma d'un procédé de correction de mesures magnétométriques selon un mode de réalisation avantageux de l'invention;
Fig. 2: une illustration schématique d'une montre connectée configurée pour mettre en oeuvre un procédé selon l'invention.

### Description d'un mode de réalisation de l'invention

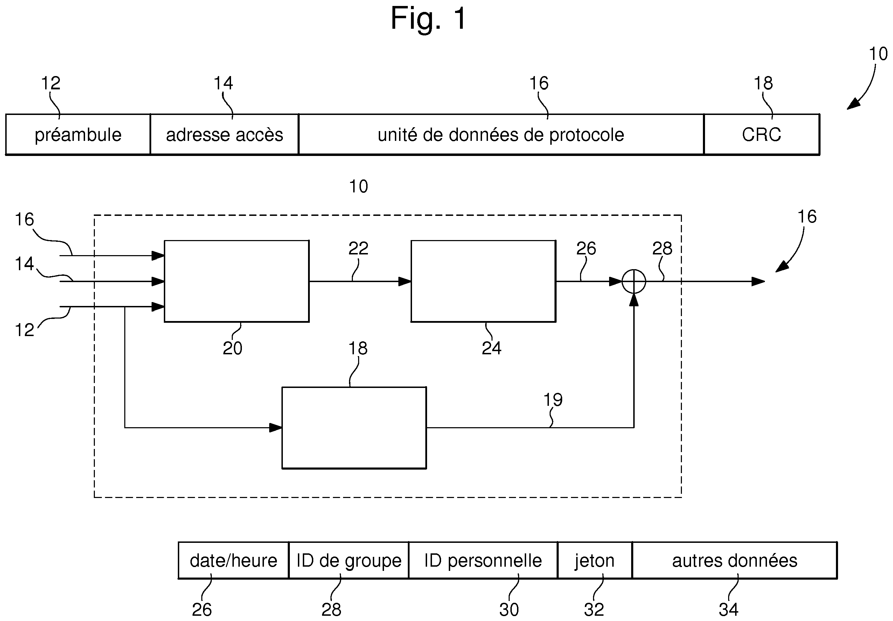

La figure 1 montre de manière schématique un procédé de correction de mesures magnétométriques 10 pouvant être mis en oeuvre par une unité de traitement d'un terminal mobile. L'unité de traitement (qui peut comprendre un ou plusieurs microprocesseurs ou circuits dédiés à l'application) reçoit en entrée
∘ les mesures d'un magnétomètre 12 (c.-à-d. les composantes du vecteur du champ magnétique dans le référentiel du terminal mobile),
∘ les mesures d'une centrale à inertie 14 (c.-à-d. des accélérations et des vitesses angulaires), et
∘ les mesures d'un récepteur GNSS/GPS 16 (c.-à-d. des positions, des vitesses et les temps dans le repère du GNSS/GPS en question).

L'unité de traitement 10 traite les mesures 12 de manière conventionnelle (p.ex. filtrage, lissage, conversion en coordonnées sphériques ou polaires, etc.) pour produire une indication du Nord 19, normalement exprimée sous la forme d'un angle par rapport à un axe du terminal mobile. Ce traitement conventionnel est schématiquement représenté par le bloc fonctionnel 18. Si l'indication du Nord porte sur le Nord géographique, le traitement conventionnel tient compte de la déclinaison magnétique valable à l'endroit du terminal mobile.

Les mesures 12, 14 et 16 sont injectées dans un processus mettant en oeuvre un algorithme d'intelligence artificielle. Les mesures 12, 14 et 16 fournies par les capteurs sont d'abord soumises à un prétraitement 20 (comprenant p.ex. du filtrage, du lissage, des conversions, etc.) pour être transformées en un vecteur de caractéristiques (en anglais : « feature vector »). Le vecteur de caractéristiques 20 sert comme donnée d'entrée dans un processus qui met en oeuvre l'algorithme d'intelligence artificielle 24 proprement dit. L'algorithme a été préalablement entraîné, au moyen de données d'apprentissage, à trouver une correction 26 pour l'indication du Nord 19. A chaque pas de temps, l'algorithme produit la correction 26 la plus probable en fonction des vecteurs de caractéristiques (et donc des mesures 12, 14 et 16) enregistrées pendant un intervalle de temps défini. L'indication du Nord corrigée 28 est obtenue par addition de la correction 26 à l'indication du Nord produite par le bloc fonctionnel 18.

Il convient de noter que le prétraitement des mesures 12, 14 et 16 est optionnel. Il serait en effet possible d'injecter les mesures brutes dans le bloc d'intelligence artificielle (à condition que celui-ci ait été préalablement entraîné avec des mesures brutes).

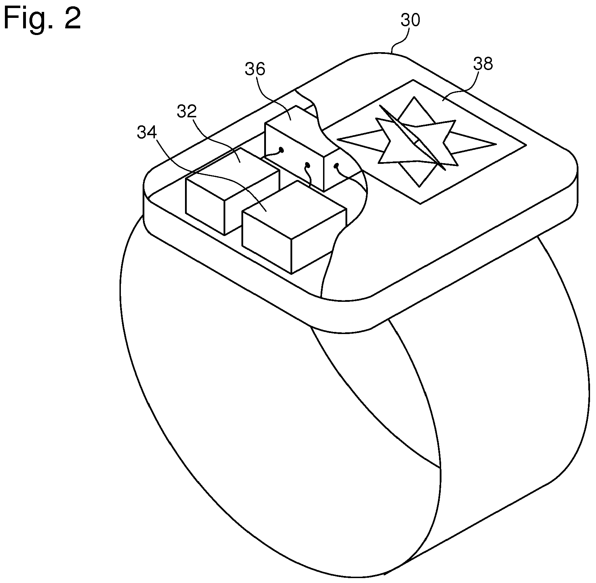

La figure 2 est une illustration schématique d'une montre connectée 30 équipée d'un magnétomètre 32, d'une centrale à inertie MEMS 34 et d'un microprocesseur 36 configuré pour mettre en oeuvre un procédé de correction de mesures magnétométriques en conformité avec l'invention. Le microprocesseur 36 déduit les mesures magnétométriques corrigées à partir des mesures magnétométriques brutes fournies par le magnétomètre 32 et des mesures de mouvement (plus précisément : d'accélération et de vitesse angulaire) fournies par la centrale à inertie 34. Les mesures magnétométriques corrigées sont mises à disposition des applications mobiles installées sur la montre connectée, p.ex. une application de boussole 38.

L'invention porte aussi sur un programme d'ordinateur comprenant des instructions de code de programme pour l'exécution des étapes du procédé lorsque ledit programme est exécuté par l'unité de traitement 36 du terminal mobile.

Alors que des modes de réalisation particuliers viennent d'être décrits en détail, l'homme du métier appréciera que diverses modifications et alternatives à ceux-là puissent être développées à la lumière de l'enseignement global apporté par la présente divulgation de l'invention. Par conséquent, les agencements et/ou procédés spécifiques décrits ci-dedans sont censés être donnés uniquement à titre d'illustration, sans intention de limiter la portée de l'invention.

## Revendications

1. Procédé de correction de mesures magnétométriques (10) réalisées par un magnétomètre monté sur un support mobile (30), le support mobile portant, outre le magnétomètre (32), un ou plusieurs capteurs de mouvement et/ou de position (34) montés fixement par rapport au magnétomètre, le procédé (10) comprenant :
- l'obtention de mesures magnétométriques (12) et de mesures de mouvement et/ou de position (14, 16) réalisées simultanément par les magnétomètres, respectivement les capteurs de mouvement et/ou de position pendant un intervalle de temps ;
- l'inférence, par une unité de traitement (36), de mesures magnétométriques corrigées (28) sur la base des mesures magnétométriques (12) et des mesures de mouvement et/ou de position (14, 16) réalisées simultanément pendant ledit intervalle de temps.

2. Le procédé de correction de mesures magnétométriques (10) selon la revendication 1, dans lequel les mesures magnétométriques (12) réalisées par le magnétomètre pendant ledit intervalle de temps indiquent l'évolution de l'orientation du support mobile par rapport au champ magnétique externe.

3. Le procédé de correction de mesures magnétométriques (10) selon la revendication 1 ou 2, dans lequel les mesures de mouvement et/ou de position (14, 16) réalisées par les capteurs de mouvement et/ou de position pendant ledit intervalle de temps indiquent les mouvements du support mobile pendant ledit intervalle de temps.

4. Le procédé de correction de mesures magnétométriques (10) selon les revendications 2 et 3, dans lequel l'inférence des mesures magnétométriques corrigées (28) repose sur les concordances et les divergences entre, d'une part, l'évolution de l'orientation du support mobile par rapport au champ magnétique externe et, d'autre part, les mouvements du support mobile.

5. Le procédé de correction de mesures magnétométriques (10) selon l'une quelconque des revendications 1 à 4, dans lequel les mesures de mouvement et/ou de position (14, 16) comprennent des mesures réalisées par un ou plusieurs accéléromètres.

6. Le procédé de correction de mesures magnétométriques (10) selon l'une quelconque des revendications 1 à 5, dans lequel les mesures de mouvement et/ou de position (14, 16) comprennent des mesures réalisées par un ou plusieurs gyromètres.

7. Le procédé de correction de mesures magnétométriques (10) selon l'une quelconque des revendications 1 à 4, dans lequel les mesures de mouvement et/ou de position (14, 16) comprennent des mesures réalisées par une centrale à inertie (14) comprenant un ou plusieurs accéléromètres et un ou plusieurs gyromètres.

8. Le procédé de correction de mesures magnétométriques (10) selon l'une quelconque des revendications 1 à 7, dans lequel les mesures de mouvement et/ou de position (14, 16) comprennent des mesures réalisées par un ou plusieurs récepteurs GNSS (16).

9. Le procédé de correction de mesures magnétométriques (10) selon l'une quelconque des revendications 1 à 8, dans lequel les mesures de mouvement et/ou de position proviennent de plusieurs capteurs et sont hybridées entre elles avant l'inférence des mesures magnétométriques corrigées.

10. Le procédé de correction de mesures magnétométriques (10) selon l'une quelconque des revendications 1 à 9, dans lequel l'inférence des mesures magnétométriques corrigées est réalisée à la volée.

11. Le procédé de correction de mesures magnétométriques (10) selon l'une quelconque des revendications 1 à 10, dans lequel le support mobile comprend un terminal mobile.

12. Le procédé de correction de mesures magnétométriques (10) selon l'une quelconque des revendications 1 à 10, dans lequel le support mobile comprend une montre connectée (30).

13. Le procédé de correction de mesures magnétométriques (10) selon l'une quelconque des revendications 1 à 12, dans lequel l'unité de traitement (36) comprend un ou plusieurs microprocesseurs et dans lequel l'unité de traitement infère les mesures magnétométriques corrigées (28) par le biais d'un algorithme d'intelligence artificielle (24).

14. Le procédé de correction de mesures magnétométriques (10) selon la revendication 13, dans lequel l'algorithme d'intelligence artificielle (24) utilise au moins un des algorithmes suivants : un réseau bayésien, un réseau de neurones, une machine à vecteur de support, la méthode des k plus proches voisins, un algorithme génétique, un arbre décisionnel, une forêt d'arbres décisionnels, un modèle de mixture gaussienne, la régression logistique et l'analyse discriminante linéaire.

15. Le procédé de correction de mesures magnétométriques (10) selon l'une quelconque des revendications 1 à 14, comprenant la transmission de mesures magnétométriques (12) et de mesures de mouvement et/ou de position (14, 16) réalisées simultanément ou de grandeurs déduites de celles-ci vers une plateforme informatique en nuage et la réception de paramètres de mise à jour du logiciel exécuté par l'unité de traitement pour les mesures magnétométriques corrigées.

16. Terminal mobile (30), comprenant un magnétomètre (32), un ou plusieurs capteurs de mouvement et/ou de position (34) montés fixement par rapport au magnétomètre, et une unité de traitement (36) reliée au magnétomètre et au(x) capteur(s) de mouvement et/ou de position pour obtenir des mesures magnétométriques (12) et des mesures de mouvement et/ou de position (14, 16) réalisées simultanément par le magnétomètre (32), respectivement le(s) capteur(s) de mouvement et/ou de position (34) pendant un intervalle de temps, dans lequel l'unité de traitement (36) est configurée, au moyen d'un programme informatique, pour inférer des mesures magnétométriques corrigées (28) sur la base des mesures magnétométriques (12) et des mesures de mouvement et/ou de position (14, 16) réalisées simultanément pendant ledit intervalle de temps.

17. Terminal mobile, selon la revendication 16, réalisé en tant que montre connectée (30).

18. Programme d'ordinateur comprenant des instructions de code de programme pour l'exécution des étapes du procédé selon l'une quelconque des revendications 1 à 15 lorsque ledit programme est exécuté par une unité de traitement (36) d'un terminal mobile.
